# EUROPEAN PATENT SPECIFICATION

(11) **EP 3 870 466 B1**
(45) Date of publication and mention of the grant of the patent: **15.06.2022**
(21) Application number: 19801217.1
(22) Date of filing: 23.10.2019
(51) Int. Cl.: B60H 1/22, B60H 1/14, H05K 7/20, B60H 1/00

(54) **ELECTRIC POWER CONVERTER DEVICE**
ELEKTRISCHE STROMRICHTERVORRICHTUNG
DISPOSITIF CONVERTISSEUR DE PUISSANCE ÉLECTRIQUE

(30) Priority: 26.10.2018 EP 18202899
(43) Date of publication of application: 01.09.2021
(73) Proprietor: MAHLE International GmbH, 70376 Stuttgart (DE)
(72) Inventor: CASTILLO, Jose Antonio, 46184 San Antonio de Benageber (ES); HALLBERG, Torbjorn, 46023 Valencia (ES); JORDAN HERRERO, Donato, 46178 La Yesa (ES); PEREZ, Alfredo, 16200 Motila des Palancar (ES); WALTER, Christoph, 70469 Stuttgart (DE)
(74) Representative: BRP Renaud & Partner mbB Rechtsanwälte Patentanwälte Steuerberater
(86) International application number: PCT/EP2019/078850
(87) International publication number: WO 2020/083977

(56) References cited:
- EP-A1- 2 562 016
- EP-A1- 2 787 529
- WO-A1-93/02884
- DE-A1-102011 108 188
- JP-A- 2017 533 862
- US-A1- 2013 330 578
- US-B2- 7 548 042

## Description

The present invention relates to an electric power converter device as well as to a method which uses the electric power converter device in a vehicle.

The operation of a modern vehicle requires an electric heating device providing a predefined amount of heat energy. The heat energy may be used to provide a comfortable air temperature for passengers in a vehicle, to heat a high voltage battery unit or to defrost a windshield in cold conditions. In the case of vehicles with conventional combustion engines such electric heating devices are typically used during a cold start phase in which the waste heat generated by the combustion engine is not sufficient to generate the required amount of heat. In hybrid vehicles or fully electrically powered vehicles, the required amount of heat is generated by the electric heating device even after a starting phase.

Such electric heating devices, which are used solely for heating, are designed as separate modules requiring additional installation space in the vehicle and increase the weight of the vehicle. Such a separate module may comprise a PTC heater element which is driven by power electronics. PTC stands for positive temperature or thermal coefficient. A PTC element is a semiconductor that generates heat when electrical current flows through it, wherein the electrical resistance of the PTC element depends on temperature. Therefore, a PTC element or PTC heater is a self-regulating heating element. Such a PTC element can also be named as Thermistor. The heat generated by the PTC heater is used to increase the temperature of a coolant in a HVAC system.

The cooling of power electronics unit of a vehicle with a cooling fluid is described in US 2010/0315780 A1. The cooling fluid, as it flows out of the power electronics unit, is cooled by radiating heat in a radiator, after which the cooling fluid circulates back into the power electronics unit to cool it.

US 7 548 042 B2 discloses a DC converter device for use in motor vehicle on-board power supply, which operates with high and low efficiencies in respective modes, so that it releases high power loss in latter operation mode for usage in warming phase.

The present invention is based on the task of specifying an electric heating device which requires less additional installation space in the vehicle compared to the state of the art known electric heating devices.

This problem is solved according to the invention by the subject matter of the independent claims. Advantageous embodiments are the subject matter of the dependent claims.

The present invention is based on the general concept that at least an electric power converter in the vehicle is used to heat a part of a vehicle.

The innovative electric power converter device comprises at least one power electronics unit being electrically connected to an electric power input and an electric power output. The electric power input and the electric power output may be electrically connected to an electric power source.

The electric power converter device has at least one fluid chamber that is fluidically connected to a fluid inlet and a fluid outlet. The fluid inlet and the fluid outlet may be fluidically connected to fluid circuit which may comprise a fluid convey unit for conveying a fluid in the fluid circuit.

The fluid chamber and the power electronics unit are thermally coupled such that waste heat generated by the power electronics unit is used for heating the fluid flowing through the fluid chamber. As the fluid flows out of the the fluid chamber, it is used to heat a part of the vehicle. The power electronics unit or the electric power converter device may comprise a first housing and a second housing which are separated by a plate. The first housing and the plate may form a first space area while the second housing and the plate form the fluid chamber with a second space area. The plate may be a thermally conductive plate which is as thin as possible for a given fluid pressure in the fluid circuit. The power electronics unit may be arranged in the first space area. The first space area may have a volume between 2 litres and 3 litres, preferably 2.6 litres. The second space area may have a volume up to 1 litre, preferably 0.4 litres.

The electric power converter device has a first operation mode and a second operation mode, wherein the amount of waste heat generated by the power electronics unit is increased in the second operation mode compared to the first operation mode. In the first operation mode, the waste heat by the power electronics unit is a byproduct since the main task of the power electronics unit is the control and conversion of electric power. In the second operation mode, the operating of the power electronics unit is increased in such a way that the generated amount of waste heat is increased. The second operation may comprise an increasing of the switching frequency of components of the power electronics unit.

The electric power converter device and/or in the vehicle may comprise a control unit which may be formed and/or programmed to switch the operation mode of the electric power converter device. The electric power converter device may be operated in the second operation mode during a cold start phase of a vehicle for a predefined time period. It may be intended that the power converter device is operated for a first predefined time period in the first operation mode, followed by a second predefined time period in which the power converter device is operated in the second operation mode. The first predefined time and second predefined time period may be repeated periodically.

It may be intended that the temperature of the electric power converter device is continuously measured and/or monitored by the control unit. ASIL (Automotive Safety Integrity Level) relevant countermeasures may be included to avoid an excess of heat in electric power converter device.

Since the electric power converter device is used as power converter and electric heating devices, no separate electric heating device is required. Due to this, installation space in the vehicle is saved and the weight of the vehicle is reduced. By sharing existing electronics components, production costs of the vehicle can be saved.

According to the invention, the electric power converter device comprises at least one heating unit being electrically connected to an electric power input and electric power output. The fluid chamber and the heating unit are thermally coupled, wherein the heating unit is used to heat the fluid flowing through the fluid chamber. The heating unit provide an additional amount of heat energy that can be transferred to the fluid in cases where the power electronics unit do not provide the required amount of heat energy. The heating unit may be operated simultaneously with the power electronics unit while the power electronics unit is operated in the first operation mode and/or second operation mode.

The heating unit may be controlled by the control unit of the power converter device and/or vehicle. It may be intended that the heating unit has a first operation mode and a second operation mode, wherein the amount of heat generated by the heating unit is increased in the second operation mode compared to the first operation mode.

In a further advantageous embodiment of the solution according to the invention, the power electronics unit forms a DC-to-DC converter unit or an AC-to-AC converter unit or an AC-to-DC converter unit or an AC-to-DC converter unit. The power electronics unit may form an on board charger or a traction inverter.

The power electronics unit that may form a DC-to-DC converter unit converts a high voltage of 400 V to a low voltage of 12 V, wherein a heating power in the range of 3 kW to 4 kW, preferably 3.6 kW, is provided. Additionally, the heating unit may provide heating power in the range of 2 kW to 4 kW, preferably in the range of 2.5 kW to 3 kW.

In a further advantageous embodiment of the solution according to the invention, the heating unit comprises a PTC element and/or a thick film resistor and/or an induction module. A PTC element may serve as a heating resistor to convert electrical energy into heat energy. A PTC element is a temperature-dependent resistor with a positive temperature coefficient (PTC = Positive Temperature Coefficient) providing a non-linear correlation between electrical resistance and temperature of the PTC thermistor element. If a limit temperature is exceeded, the electrical resistance of the PTC thermistor element increases non-linearly with increasing temperature.

In a further advantageous embodiment of the solution according to the invention, the switching frequency of the power electronics unit is increased in the second operation mode in order to increase the amount of heat energy.

According to the invention, the electric power converter device comprises a first housing and a second housing, wherein the first housing and the second housing are separated by a fluid-impermeable plate, wherein the first housing and the plate form a first space area in which the power electronics unit and a heating unit are arranged, wherein the plate and the second housing form the fluid chamber with a second space area. The first space area may have a volume larger than the second space area. The first space area may have a volume between 2 litres and 3 litres, preferably 2.6 litres. The second space area may have a volume up to 1 litre, preferably 0.4 litres.

According to the invention, the power electronics unit forms a DC-to-DC converter which converts a high voltage of 400 V to a low voltage of 12 V, wherein a heating power in the range of 3 kW to 4 kW, preferably 3.6 kW, is provided.

The invention further relates to a method of heating a part of a vehicle. At least one electric power converter device and a fluid circulating in fluid circuit are provided, wherein the fluid is heated by waste heat of the electric power converter device. The fluid circuit may comprise a fluid convey unit for conveying a fluid in the fluid circuit. The electric power converter device and/or in the vehicle may comprise a control unit which may be formed and/or programmed to control and/or to perform the method.

In a further advantageous embodiment of the solution according to the invention, the electric power converter device forms an electric power converter device according to the invention with a first operation mode and a second operation mode. In a further advantageous embodiment of the solution according to the invention, the electric power converter device is operated in a heating mode for a predefined time period during which the amount of waste heat is increased. In the heating mode, the electric power converter device may be operated with a higher switching frequency in order generate more heat energy. If the electric power converter device comprises a first operating mode and a second operating mode, the second operating mode corresponds to the heating mode.

The electric power converter device may be operated in the heating mode during a cold start phase of a vehicle for a predefined time period. It may be intended that the power converter device is operated for a first predefined time period in a normal mode, followed by a second predefined time period in which the power converter device is operated in the heating mode. The first predefined time and second predefined time period may be repeated periodically.

In a further advantageous embodiment of the solution according to the invention, the fluid is a coolant or refrigerant. The fluid may flow through a cooling circuit of a part of the vehicle. The may be used to transfer heat energy to the part of the vehicle.

In a further advantageous embodiment of the solution according to the invention, the part of a vehicle is a space area of the vehicle and/or a battery unit and/or a vehicle interior. The battery unit may comprise a lithium-ion battery which has to be operated in a predefined temperature range in order to ensure an optimal operation of the battery unit. Given low temperature conditions, the electric power converter device can be used to heat the battery unit as long as needed to reach the required temperature range.

In a further advantageous embodiment of the solution according to the invention, the vehicle is an electrical vehicle. Such an electrical vehicle may be a hybrid vehicle or a fully electrically powered vehicle or a fuel cell electric vehicle. Since such vehicles do not have an internal-combustion engine, the required amount of heat energy has to be provided by electronic components of the vehicle. As the invention uses electronics components of the vehicle in an inventive way, installation space in the vehicle is saved and the weight of the vehicle is reduced. Additionally, the production costs of the vehicle can be reduced.

In a further advantageous embodiment of the solution according to the invention, the power converter device is operated for a first predefined time period in a normal mode, followed by a second predefined time period in which the power converter device is operated in the heating mode, wherein the first predefined time period and second predefined time period are repeated periodically.

Further important features and advantages of the invention emerge from the dependent claims, from the drawings and from the associated description of the figures with reference to the drawings.

It goes without saying that the features mentioned above and those which have yet to be explained below can be used not only in the respectively stated combination, but also in different combinations or on their own without departing from the scope of the present invention.

Preferred exemplary embodiments of the invention are illustrated in the drawings and are explained in more detail in the description below, wherein the same reference signs refer to identical or similar or functionally identical components.

In the drawings, in each case schematically, are depicted
- Fig. 1: an electric power converter device according to the invention,
- Fig. 2: a vehicle with an electric power converter device according to the invention.

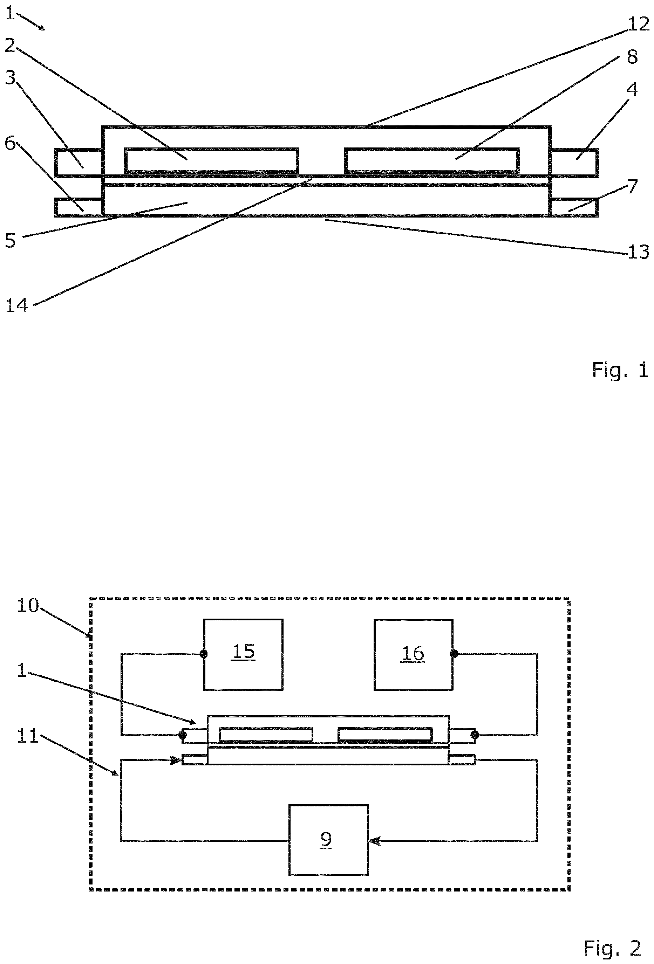

The electric power converter device 1 shown in the Fig. 1 comprises a first housing 12 and a second housing 13. The first housing 12 and the second housing 13 are separated by a plate 14 which is essentially impermeable to fluids.

The first housing 12 provides an electric power input 3 and an electric power output 4. The second housing 13 provides a fluid inlet 6 and a fluid outlet 7.

The first housing 12 and the plate 14 form a first space area in which a power electronics unit 2 and a heating unit 8 are arranged. The power electronics unit 2 is electrically connected to the electric power input 3 and electric power output 4 by electrically conductive lines which are not shown. The heating unit 8 is electrically connected to the electric power input 3 and electric power output 4 by electrically conductive lines which are not shown. The electronics unit 2 and the heating unit 8 may be thermally coupled to the plate. Heat energy that is generated during the operation of the power electronics unit 2 and/or during the operation of the heating unit 8 is transferred by the plate 14 to a second space area. The occupied volume by the first space area may be smaller than the occupied volume by the second space area.

The plate 14 and the second housing 13 form a fluid chamber 5 with the second space area. The fluid chamber 5 comprises a fluid inlet 6 and a fluid outlet 7. A fluid may enter the fluid chamber 5 through the fluid inlet 6 and leaves the fluid chamber 5 through the fluid outlet 7. While the fluid flows through the fluid chamber 5, it absorbs heat energy that is transferred by the plate 14 from the first space area to the second space area.

As shown in the Fig. 2, the electric power input 3 is electrically connected to an electric power source 15 by electrically conductive lines. The electric power 15 source may be a battery unit of a vehicle 10 or a charging station. The electric power output 4 is electrically connected to a device 16 of the vehicle by electrically conductive lines. Since the device 16 cannot be directly driven by the electric power of the electric power source 15, the power electronics unit 2 converts and/or control the electric power that is used to drive the electrical device 16. The device 16 may be an electrical machine converting electrical energy into mechanical energy.

The fluid chamber 5 is fluidically connected to a fluid circuit 11 with a part 9 of the vehicle 10. The part 9 may be a battery unit or an HVAC unit. The fluid circuit 11 comprises fluid lines and at least one fluid pump that is not shown. The fluid pump may be used for pumping a fluid in the fluid circuit 11.

The electric power converter device 1 may be operated in the heating mode for a predefined time period. During this predefined time period, the power electronics unit 2 may be operated in a mode providing a higher amount of heat energy. Additionally, the heating unit 8 may be switched on in order to provide additional amount of heat energy. It may be intended that the power converter device 1 is operated for a first predefined time period in a normal mode, followed by a second predefined time period in which the power converter device 1 is operated in the heating mode. The first predefined time and second predefined time period may be repeated periodically.

A vehicle 10 may comprise several electric power converter devices 1 in order to increase the amount of provided heat energy. This can be advantageous, for example, for air conditioning in buses.

## Claims

1. An electric power converter device (1) comprising:
- at least one power electronics unit (2) being electrically connected to an electric power input (3) and an electric power output (4),
- at least one fluid chamber (5) being fluidically connected to a fluid inlet (6) and a fluid outlet (7),
- wherein the fluid chamber (5) and the power electronics unit (2) are thermally coupled such that waste heat generated by the power electronics unit (2) is used for heating a fluid flowing through the fluid chamber (5),
- wherein the electric power converter device (1) has a first operation mode and a second operation mode,
- wherein the amount of waste heat generated by the power electronics unit (2) is increased in the second operation mode compared to the first operation mode, **characterized in that** it comprises:
- at least one heating unit (8) being electrically connected to an electric power input (3) and electric power output (4),
- the fluid chamber (5) and the heating unit (8) being thermally coupled,
- wherein the heating unit (8) is used to heat a fluid flowing through the fluid chamber (5),
- wherein electric power converter device (1) comprises a first housing (12) and a second housing (13),
- wherein the first housing (12) and the second housing (13) are separated by a fluid-impermeable plate (14),
- wherein the first housing (12) and the plate (14) form a first space area in which the power electronics unit (2) and a heating unit (8) are arranged,
- wherein the plate (14) and the second housing (13) form the fluid chamber (5) with a second space area,
- wherein the power electronics unit (2) forms a DC-to-DC converter which converts a high voltage of 400 V to a low voltage of 12 V, wherein a heating power in the range of 3 kW to 4 kW, preferably 3.6 kW, is provided.

2. The electric power converter device (1) according to claim 1,
wherein the heating unit (8) comprises a PTC element and/or a thick film resistor and/or an induction module.

3. The electric power converter device (1) according to claim 1or 2,
whereby the switching frequency of the power electronics unit (2) is increased in the second operation mode.

4. The electric power converter device (1) according to any one of the preceding claims,
- wherein the power electronics unit (2) forms an on board charger, and/or
- wherein a heating unit (8) provides heating power in the range of 2 kW to 4 kW, preferably in the range of 2.5 kW to 3 kW.

5. A method of heating a part (9) of a vehicle (10), the method comprising:
- providing at least one electric power converter device (1),
- providing a fluid circulating in fluid circuit (11),
- wherein the fluid is heated by waste heat of the electric power converter device (1)
- wherein the electric power converter device (1) forms an electric power converter device according to one of claims 1 to 4.

6. A method according to claim 5,
wherein the electric power converter device (1) is operated in a heating mode for a predefined time period during which the amount of waste heat is increased.

7. A method according to one of claims 5 to 6,
wherein the fluid is a coolant or refrigerant.

8. A method according to one of claims 5 to 7,
wherein the part (9) of a vehicle (10) is a space area of the vehicle and/or a battery unit and/or a vehicle interior.

9. A method according to one of claims 5 to 8,
wherein the vehicle (10) is an electrical vehicle.

10. A method according to one of claims 5 to 9,
- wherein the power converter device (1) is operated for a first predefined time period in a normal mode, followed by a second predefined time period in which the power converter device (1) is operated in the heating mode,
- wherein the first predefined time period and second predefined time period are repeated periodically.

## Patentansprüche

1. Elektrische Leistungswandlervorrichtung (1), umfassend:
- mindestens eine Leistungselektronikeinheit (2), die elektrisch mit einem elektrischen Leistungseingang (3) und einem elektrischen Leistungsausgang (4) verbunden ist,
- mindestens eine Fluidkammer (5), die mit einem Fluideinlass (6) und einem Fluidauslass (7) fluidisch verbunden ist,
- wobei die Fluidkammer (5) und die Leistungselektronikeinheit (2) thermisch gekoppelt sind, so dass die von der Leistungselektronikeinheit (2) erzeugte Abwärme zum Erwärmen eines durch die Fluidkammer (5) strömenden Fluids verwendet wird,
- wobei die elektrische Leistungswandlervorrichtung (1) einen ersten Betriebsmodus und einen zweiten Betriebsmodus aufweist,
- wobei die von der Leistungselektronikeinheit (2) erzeugte Abwärmemenge in der zweiten Betriebsart im Vergleich zur ersten Betriebsart erhöht ist, **dadurch gekennzeichnet, dass** sie Folgendes umfasst:
- mindestens eine Heizeinheit (8), die elektrisch mit einem elektrischen Leistungseingang (3) und einem elektrischen Leistungsausgang (4) verbunden ist,
- wobei die Fluidkammer (5) und die Heizeinheit (8) thermisch gekoppelt sind,
- wobei die Heizeinheit (8) zum Erwärmen eines durch die Fluidkammer (5) strömenden Fluids verwendet wird,
- wobei die elektrische Leistungswandlervorrichtung (1) ein erstes Gehäuse (12) und ein zweites Gehäuse (13) umfasst,
- wobei das erste Gehäuse (12) und das zweite Gehäuse (13) durch eine fluidundurchlässige Platte (14) getrennt sind,
- wobei das erste Gehäuse (12) und die Platte (14) einen ersten Raumbereich bilden, in dem die Leistungselektronikeinheit (2) und eine Heizeinheit (8) angeordnet sind,
- wobei die Platte (14) und das zweite Gehäuse (13) die Fluidkammer (5) mit einer zweiten Raumfläche bilden,
- wobei die Leistungselektronikeinheit (2) einen Gleichspannungswandler bildet, der eine Hochspannung von 400 V in eine Niederspannung von 12 V umwandelt, wobei eine Heizleistung im Bereich von 3 kW bis 4 kW, bevorzugt 3,6 kW, bereitgestellt wird.

2. Elektrische Leistungswandlervorrichtung (1) nach Anspruch 1,
wobei die Heizeinheit (8) ein PTC-Element und/oder einen Dickschichtwiderstand und/oder ein Induktionsmodul umfasst.

3. Elektrische Leistungswandlervorrichtung (1) nach Anspruch 1 oder 2,
wodurch die Schaltfrequenz der Leistungselektronikeinheit (2) in der zweiten Betriebsart erhöht wird.

4. Elektrische Leistungswandlervorrichtung (1) nach einem der vorstehenden Ansprüche,
- wobei die Leistungselektronikeinheit (2) ein On-Board-Ladegerät bildet, und/oder
- wobei eine Heizeinheit (8) eine Heizleistung im Bereich von 2 kW bis 4 kW, bevorzugt im Bereich von 2,5 kW bis 3 kW, bereitstellt.

5. Verfahren zum Erwärmen eines Teils (9) eines Fahrzeugs (10), das Verfahren umfassend:
- Bereitstellung mindestens einer elektrischen Leistungswandlervorrichtung (1),
- Bereitstellung eines im Fluidkreislauf (11) zirkulierenden Fluids,
- wobei das Fluid durch die Abwärme der elektrischen Leistungswandlervorrichtung (1) erwärmt wird
- wobei die elektrische Leistungswandlervorrichtung (1) eine elektrische Leistungswandlervorrichtung nach einem der Ansprüche 1 bis 4 bildet.

6. Verfahren nach Anspruch 5,
wobei die Leistungswandlervorrichtung (1) für eine vordefinierte Zeitspanne in einem Heizmodus betrieben wird, in dem die Abwärmemenge erhöht wird.

7. Verfahren nach einem der Ansprüche 5 bis 6,
wobei das Fluid ein Kühlmittel oder Kältemittel ist.

8. Verfahren nach einem der Ansprüche 5 bis 7,
wobei der Teil (9) eines Fahrzeugs (10) ein Raumbereich des Fahrzeugs und/oder eine Batterieeinheit und/oder ein Fahrzeuginnenraum ist.

9. Verfahren nach einem der Ansprüche 5 bis 8,
wobei das Fahrzeug (10) ein Elektrofahrzeug ist.

10. Verfahren nach einem der Ansprüche 5 bis 9,
- wobei die Leistungswandlervorrichtung (1) für eine erste vordefinierte Zeitspanne in einem Normalmodus betrieben wird, gefolgt von einer zweiten vordefinierten Zeitspanne, in der die Leistungswandlervorrichtung (1) im Heizmodus betrieben wird,
- wobei die erste vordefinierte Zeitspanne und die zweite vordefinierte Zeitspanne periodisch wiederholt werden.

## Revendications

1. Dispositif convertisseur de puissance électrique (1) comprenant :
- au moins une unité électronique de puissance (2) qui est connectée électriquement à une entrée de puissance électrique (3) et une sortie de puissance électrique (4),
- au moins une chambre de fluide (5) qui est connectée de manière fluidique à une admission de fluide (6) et une évacuation de fluide (7),
- dans lequel la chambre de fluide (5) et l'unité électronique de puissance (2) sont couplées thermiquement de telle sorte qu'une chaleur résiduelle générée par l'unité électronique de puissance (2) soit utilisée pour chauffer un fluide s'écoulant à travers la chambre de fluide (5),
- dans lequel le dispositif convertisseur de puissance électrique (1) présente un premier mode de fonctionnement et un second mode de fonctionnement,
- dans lequel la quantité de chaleur résiduelle générée par l'unité électronique de puissance (2) augmente dans le second mode de fonctionnement par rapport au premier mode de fonctionnement, **caractérisé en ce qu'**il comprend :
- au moins une unité de chauffage (8) qui est connectée électriquement à une entrée de puissance électrique (3) et une sortie de puissance électrique (4),
- la chambre de fluide (5) et l'unité de chauffage (8) étant couplées thermiquement,
- dans lequel l'unité de chauffage (8) est utilisée pour chauffer un fluide s'écoulant à travers la chambre de fluide (5),
- dans lequel un dispositif convertisseur de puissance électrique (1) comprend un premier boîtier (12) et un second boîtier (13),
- dans lequel le premier boîtier (12) et le second boîtier (13) sont séparés par une plaque imperméable aux fluides (14),
- dans lequel le premier boîtier (12) et la plaque (14) forment une première zone d'espace dans laquelle l'unité électronique de puissance (2) et une unité de chauffage (8) sont agencées,
- dans lequel la plaque (14) et le second boîtier (13) forment la chambre de fluide (5) avec une seconde zone d'espace,
- dans lequel l'unité électronique de puissance (2) forme un convertisseur c.c.-c.c. qui convertit une haute tension de 400 V en une basse tension de 12 V, dans lequel une puissance de chauffage dans la plage de 3 kW à 4 kW, de préférence de 3,6 kW, est fournie.

2. Dispositif convertisseur de puissance électrique (1) selon la revendication 1,
dans lequel l'unité de chauffage (8) comprend un élément PTC et/ou une résistance en couche épaisse et/ou un module d'induction.

3. Dispositif convertisseur de puissance électrique (1) selon la revendication 1 ou 2,
selon lequel la fréquence de commutation de l'unité électronique de puissance (2) augmente dans le second mode de fonctionnement.

4. Dispositif convertisseur de puissance électrique (1) selon l'une quelconque des revendications précédentes,
- dans lequel l'unité électronique de puissance (2) forme un chargeur embarqué, et/ou
- dans lequel une unité de chauffage (8) fournit une puissance de chauffage dans la plage de 2 kW à 4 kW, de préférence dans la plage de 2,5 kW à 3 kW.

5. Procédé de chauffage d'une partie (9) d'un véhicule (10), le procédé comprenant :
- une fourniture d'au moins un dispositif convertisseur de puissance électrique (1),
- une fourniture d'un fluide circulant dans un circuit de fluide (11),
- dans lequel le fluide est chauffé par une chaleur résiduelle du dispositif convertisseur de puissance électrique (1)
- dans lequel le dispositif convertisseur de puissance électrique (1) forme un dispositif convertisseur de puissance électrique selon l'une des revendications 1 à 4.

6. Procédé selon la revendication 5,
dans lequel le dispositif convertisseur de puissance électrique (1) fonctionne dans un mode de chauffage pendant une période de temps prédéfinie durant laquelle la quantité de chaleur résiduelle augmente.

7. Procédé selon l'une des revendications 5 à 6,
dans lequel le fluide est un liquide de refroidissement ou un fluide frigorigène.

8. Procédé selon l'une des revendications 5 à 7,
dans lequel la partie (9) d'un véhicule (10) est une zone d'espace du véhicule et/ou une unité batterie et/ou un habitacle.

9. Procédé selon l'une des revendications 5 à 8,
dans lequel le véhicule (10) est un véhicule électrique.

10. Procédé selon l'une des revendications 5 à 9,
- dans lequel le dispositif convertisseur de puissance (1) fonctionne pendant une première période de temps prédéfinie dans un mode normal, suivie d'une seconde période de temps prédéfinie dans laquelle le dispositif convertisseur de puissance (1) fonctionne dans le mode de chauffage,
- dans lequel les première période de temps prédéfinie et seconde période de temps prédéfinie sont répétées périodiquement.
